# NEUE EUROPÄISCHE PATENTSCHRIFT

(11) **EP 1 635 366 B2**
(45) Veröffentlichungstag und Bekanntmachung des Hinweises auf die Entscheidung über den Einspruch: **16.03.2011**
(45) Hinweis auf die Patenterteilung: 24.10.2007
(21) Anmeldenummer: 05400031.0
(22) Anmeldetag: 12.09.2005
(51) Int. Cl.: H01H 3/02

(54) **Schaltereinheit**
Switch unit
Bloc interrupteur

(30) Priorität: 10.09.2004 DE 102004044378
(43) Veröffentlichungstag der Anmeldung: 15.03.2006
(73) Patentinhaber: Valeo Schalter und Sensoren GmbH, 74321 Bietigheim-Bissingen (DE)
(72) Erfinder: Staude, Sascha, 74321 Bietigheim-Bissingen (DE); Bosch, Jürgen, 86757 Wallerstein (DE)
(74) Vertreter: Vötsch, Reiner

(56) Entgegenhaltungen:
- DE-A1- 3 910 977
- DE-C- 3 906 859
- US-A- 5 270 710
- US-B1- 6 774 505

## Beschreibung

Die Erfindung betrifft eine Schaltereinheit mit einem Grundteil und einem gegenüber dem Grundteil bewegbaren Betätigungselement, wobei durch die Bewegung des Betätigungselements ein elektrischer Kontakt schließbar ist und wobei der Berührungssensor Felderzeugungsmittel zur Erzeugung eines elektrischen Feldes und eine Auswerteelektronik zur Überwachung der Änderung des elektrischen Feldes und zur Erzeugung des Schaltsignals bei sich änderndem elektrischen Feld umfasst. Das Betätigungselement kann dabei insbesondere von einer menschlichen Person betätigt werden. Je nach Führung des Betätigungselements kann dieses gegenüber dem Grundteil, insbesondere entlang einer Richtung betätigt werden, verschwenkt werden oder auch verdreht werden.

Es ist wünschenswert, mit einer derartigen Schaltereinheit mehrere Schaltstufen zu realisieren. Dabei ist bekannt, das Betätigungselement derart auszubilden, dass es aufgrund seiner Bewegung mehrere, hintereinander liegende Schaltzustände einnehmen kann. Dies erfordert allerdings einen entsprechend großen Bauraum und eine entsprechend aufwändige Lagerungsmechanik des Betätigungselements gegenüber dem Grundteil.

Aus der US 6,774,505 B1 ist eine Fahrzeugschaltereinrichtung bekannt geworden, bei der am Schaltergehäuse ein Näherungsschalter angeordnet ist, der bei Annäherung einer menschlichen Hand eine Leuchtmittel ansteuert.

Aus der US 5,270,170 ist eine Umschaltvorrichtung mit doppeltem Betriebsmodus bekannt geworden, wobei im ersten Betriebsmodus eine Näheerfassung detektierbar ist und im zweiten Betriebsmodus ein mechanischer Kontakt geschlossen wird. In beiden Betriebsmodi werden identische Bauteile verwendet.

Der vorliegenden Erfindung liegt die Aufgabe zugrunde, eine Schaltereinheit der eingangs genannten Art bereitzustellen, bei der wenigstens zwei Schaltstufen realisiert werden können, wobei möglichst wenig Bauraum beansprucht werden soll und die Schaltereinheit einen möglichst einfachen Aufbau aufweisen soll.

Diese Aufgabe wird mit einer Schaltereinheit mit den Merkmalen des Patentanspruchs 1 oder des Anspruchs 2 gelöst.

Die erfindungsgemäße Schaltereinheit hat den Vorteil, dass die erste Schaltstufe bei Berührung des Betätigungselements oder bei Annäherung des Betätigungselements erfolgt, ohne dass das Betätigungselement gegenüber dem Grundteil bewegt wird. Die zweite Schaltstufe wird dann durch die Bewegung des Betätigungselements eingeleitet. Insofern können zwei Schaltstufen realisiert werden, ohne dass zusätzlicher Bauraum oder eine zusätzliche Bewegungsmechanik für das Betätigungselement erforderlich ist. Insbesondere kann eine bekannte Betätigungsmechanik für das Betätigungselement Verwendung finden.

Durch den Berührungssensor wird folglich die erste Schaltstufe dann geschalten, wenn eine insbesondere manuelle Berührung des Betätigungselements oder eine Annäherung an das Betätigungselement erfolgt. Die die Schaltereinheit betätigende Person kann beispielsweise mittels eines Fingers in den Erfassungsbereich des Berührungssensors gelangen, wodurch das Schaltsignal erzeugt wird.

Dabei kann der Schaltereinheit eine frei programmierbare Schaltfunktion zugeordnet sein, wobei beim Berühren oder Annähern aufgrund des Schaltsignals auf einem Display dem Benutzer die jeweilige Schaltfunktion dargestellt werden kann (erste Schaltstufe). Ein Auslösen der eigentlichen Schaltfunktion kann dann beim mechanischen Betätigen des Betätigungselements erfolgen.

Erfindungsgemäß ist vorgesehen, dass der Berührungssensor Felderzeugungsmittel zur Erzeugung eines elektrischen Feldes und eine Auswerteelektronik zur Überwachung der Änderung des elektrischen Feldes und zur Erzeugung des Schaltsignals bei sich änderndem elektrischen Feld umfasst. Das durch das Felderzeugungsmittel erzeugte elektrische Feld wird bei Annähern an das Felderzeugungsmittel oder bei Berührung des Betätigungselements geändert; diese Änderung wird von der Auswerteelektronik erfasst. Außerdem erzeugt die Auswerteelektronik bei einer entsprechenden Feldänderung das entsprechende Schaltsignal.

Insbesondere kann die Auswerteelektronik grundteilseitig angeordnet sein, wobei die Felderzeugungsmittel entweder ebenfalls grundteilig angeordnet sein können oder vorteilhafterweise auch betätigungselementseitig angeordnet sein können. Bei einer grundteilseitigen Anordnung der Felderzeugungsmittel bewegen sich diese beim Betätigen des Betätigungselements nicht mit. Bei einer betätigungselementseitigen Anordnung bewegen sich die Felderzeugungsmittel mit der Bewegung des Betätigungselements mit.

Die Felderzeugungsmittel sind dabei derart, dass sie ein Feld erzeugen, dass das Betätigungselement umgibt oder auch durchdringt. Je nach Art des Betätigungselements können die Felderzeugungsmittel bei betätigungselementseitiger Anordnung am Betätigungselement angeordnet oder auch in das Betätigungselement integriert sein. Die Felderzeugungsmittel können beispielsweise in ein Betätigungselement aus Kunststoff eingegossen sein.

Für den Fall, dass die Felderzeugungsmittel am Betätigungselement angeordnet sind, ist es erforderlich, eine elektrische Kopplung zwischen den betätigungselementseitigen Felderzeugungsmitteln und der insbesondere grundteilseitig angeordneten Auswerteelektronik vorzusehen.

Als Felderzeugungsmittel können insbesondere Kondensatoren vorgesehen sein, die entweder am Grundteil oder am Betätigungselement angeordnet sind. Kondensatoren eignen sich deshalb, weil sie keinen, oder nur einen sehr geringen Ruhestromverbrauch haben und dennoch eine Änderung des Feldes sicher detektiert werden kann. Als Kondensatoren kommen insbesondere Kondensatorplatten in Betracht.

Bei einer vorteilhaften Ausgestaltung der Erfindung umfasst die elektrische Kopplung ein weiteres, grundteilseitiges Felderzeugungsmittel, wobei das betätigungselementseitige Felderzeugungsmittel mit dem grundteilseitigen Felderzeugungsmittel berührungslos derart in Wirkverbindung steht, dass eine Änderung des elektrischen Feldes des betätigungselementseitigen Felderzeugungsmittels eine Änderung des elektrischen Feldes des grundteilseitigen Felderzeugungsmittels bewirkt, wobei dann das grundteilseitige Felderzeugungsmittel mit der Auswerteelektronik verbunden ist. Folglich ist ein Felderzeugungsmittel an dem bewegbaren Betätigungselement und ein Felderzeugungsmittel an dem Grundteil angeordnet, wobei die beiden Felderzeugungsmittel berührungslos miteinander in Wirkverbindung stehen. Das sich ändernde Feld des betätigungselementseitigen Felderzeugungsmittels bewirkt eine Änderung des elektrischen Feldes des grundteilseitigen Felderzeugungsmittels, was von der Auswerteeinheit detektierbar ist.

Bei dieser Ausführungsform der Erfindung sind vorzugsweise beide vorzusehenden Felderzeugungsmittel als Kondensatoren ausgebildet, wobei einer der Kondensatoren den anderen Kondensator wenigstens abschnittsweise überdeckt, umgibt oder umschließt. Hierdurch wird gewährleistet, dass eine Änderung des Feldes des betätigungselementseitigen Felderzeugungsmittels sicher auf den grundteilseitigen Kondensator berührunglos übertragen wird. Die beiden Kondensatoren sind dabei so angeordnet, dass bei der Bewegung des Betätigungselements gegenüber dem Grundkörper kein Kontakt zwischen den beiden Kondensatoren erfolgt. Insbesondere können Platten-Kondensatoren, welche die eine Platte mit der anderen Platte wenigstens abschnittsweise umschließen, oder Zylinderkondensatoren, bei denen die eine Potentialfläche die andere wenigstens abschnittsweise umschließt, Verwendung finden. Dadurch kann ein Toleranzausgleich zwischen dem Grundkörper und dem Betätigungselement auf einfache Art und Weise realisiert werden.

Ferner kann vorgesehen sein, dass das Betätigungselement gegenüber dem Grundteil eine Hub-, Dreh-, Schiebe- und/oder Pendelbewegung ausführen kann. Das Betätigungselement kann dabei gegenüber dem Grundteil mehrere Schaltstellungen einnehmen.

Gemäß einer weiteren Ausführungsform der Erfindung kann ein Leuchtmittel zur Beleuchtung des Betätigungselements vorgesehen sein. Dies ist insbesondere dann vorteilhaft, wenn die Schaltereinheit bei Dunkelheit betätigt werden soll. Das Betätigungselement kann dabei vorzugsweise wenigstens abschnittsweise einen Durchbruch oder einen lichtdurchlässigen Abschnitt aufweisen.

Ferner ist erfindungsgemäß denkbar, dass die Felderzeugungsmittel zwischen dem Leuchtmittel und dem Betätigungselement angeordnet sind, wobei die Felderzeugungsmittel einen Ausschnitt oder Durchbruch für das von dem Leuchtmittel ausgesendete Licht derart umfassen können, dass das Betätigungselement wenigstens abschnittsweise durchleuchtbar ist.

Weitere Einzelheiten und vorteilhafte Ausgestaltungen der Erfindung sind der folgenden Beschreibung zu entnehmen, in der die Erfindung anhand der in der Zeichnung dargestellten Ausführungsformen näher beschrieben und erläutert ist.

Es zeigen:
- Figur 1: einen Schnitt durch eine erste Ausführungsform einer erfindungsgemäßen Schaltereinheit;
- Figur 2: einen Schnitt durch eine zweite Ausführungsform einer erfindungsgemäßen Schaltereinheit.

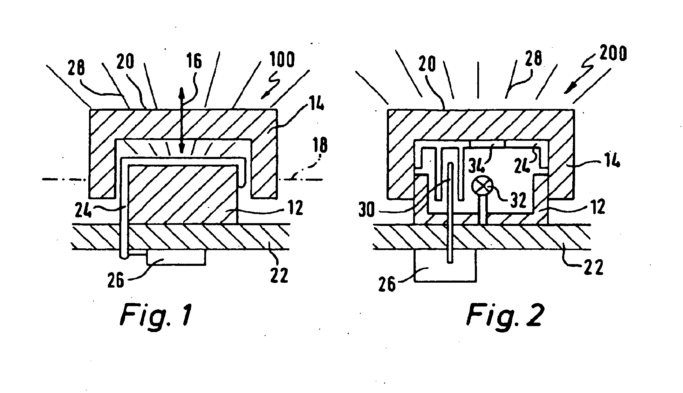

In den Figuren 1 und 2 sind verschiedene erfindungsgemäße Schaltereinheiten 100, 200dargestellt, wobei entsprechende Bauteile mit entsprechenden Bezugszeichen versehen sind.

Die in der Figur 1 im Schnitt dargestellte Schaltereinheit 100 umfasst ein Grundteil 12 und ein gegenüber dem Grundteil 12 bewegbares Betätigungselement 14. Das Betätigungselement 14 ist dabei am Grundteil 12 beweglich gelagert. Das Betätigungselement 14 kann beispielsweise eine Hubbewegung entlang des Pfeils 16 oder eine Schwenkbewegung um die Achse 18 beim Betätigen ausführen. Die Lagerstelle des Betätigungselements am Grundteil ist in den Figuren nicht dargestellt.

Das Betätigen des Betätigungselements 14 erfolgt durch Drücken auf die dem Grundteil 12 abgewandte Oberseite 20 des Betätigungselements 14. Wird das Betätigungselement 14 entsprechend manuell bewegt, so wird ein in den Figuren nicht dargestellter Kontakt geschlossen. Das Betätigungselement 14 kann dabei mehrere Schaltstellungen zur Erzeugung von mehreren Schaltstufen aufweisen.

Das Grundteil 12 ist auf einer Leiterplatte 22 befestigt.

Die Schaltereinheit 100 umfasst ferner einen Berührungssensor, mit dem bei Berühren des Betätigungselements oder bei Annäherung an das Betätigungselement ein Schaltsignal erzeugbar ist. Der Berührungssensor umfasst dabei ein Felderzeugungsmittel in Form eines Kondensators 24 sowie eine Auswerteelektronik 26. Der Kondensator 24 erzeugt dabei ein elektrisches Feld im Bereich der Oberseite 20 des Betätigungselements 14. Das elektrische Feld ist in den Figuren mit der Bezugszahl 28 angedeutet. Die mit dem Kondensator 24 gekoppelte Auswerteeinheit 26 überwacht eine Änderung des elektrischen Feldes und erzeugt ein Schaltsignal, wenn eine entsprechende Änderung des elektrischen Feldes bei Annäherung an die Oberseite 20, beziehungsweise bei Berührung der Oberseite 20, stattfindet.

Bei der Ausführungsform gemäß der Figur 1 ist der als Plattenkondensator ausgebildete Kondensator 24 direkt auf dem Grundkörper 12 unterhalb des Betätigungselements 14 angeordnet. Vorteilhafterweise wird dadurch ein möglichst homogenes elektrisches Feld gebildet, dass die Oberseite 20 möglichst senkrecht durchdringt.

Bei der Ausführungsform gemäß der Figur 2 ist der Kondensator direkt an der Innenseite des Betätigungselements 14 angeordnet. Beim Bewegen des Betätigungselements 14 wird der Kondensator 24 folglich mitbewegt. Während bei der Ausführungsform gemäß Figur 1 eine starre Kopplung in Form einer elektrischen Leitung zwischen dem Kondensator 24 und der Auswerteelektronik 26 vorgesehen ist, bedarf es bei der Ausführungsform gemäß Figur 2 einer Kopplung, die dem Bewegungsspielraum des Betätigungselements 14 Rechnung trägt. Dazu ist ein zum Kondensator 24 in Reihe angebrachter weiterer Übertragungskondensator 30 vorgesehen. Die beiden Kondensatoren 24 und 30 stehen dabei derart in Wirkverbindung miteinander, dass eine Änderung des elektrischen Feldes des Kondensators 24 eine Änderung des elektrischen Feldes des Übertragungskondensators 30 bewirkt. Der Übertragungskondensator 30 zu 24 ist dabei einseitig feststehend am Grundteil 12 angeordnet und mit der Auswerteeinheit 26 elektrisch verbunden. Die andere Seite des Kondensators 24 ist beweglich. Der Kondensator 24 zu 30 ist dabei derart angeordnet, dass sie sich über den gesamten Bewegungsraum des Betätigungselements 14 nicht berühren und dass sie sich wenigstens abschnittsweise überdecken, umgeben oder umschließen. Der Übertragungskondensator 30 zu 24 kann dabei insbesondere als umschließender Plattenkondensator, umschließender 2-Platten-Kondensator oder auch als umschließender Zylinderkondensator ausgebildet sein.

Die Schaltereinheit 200 gemäß Figur 2 hat den Vorteil, dass Lagetoleranzen des Betätigungselements 14 gegenüber dem Grundkörper 12 augrund des Luftspaltes zwischen dem Kondensatoren 24 zu 30 ausgleichbar sind. Eine Lagetoleranz hat dabei keinen Einfluss auf die Kapazität der Kondensatoren und verändert damit nicht die Sensitivität der Auswerteeinrichtung.

In der Figur 2 ist außerdem ein Leuchtmittel 32 dargestellt, mit dem das Betätigungselement 14 beleuchtbar ist. Das Betätigungselement 14 kann dabei wenigstens im zentralen Bereich als durchleuchtbar ausgebildet sein. Damit der Kondensator 24 eine Ausleuchtung nicht behindert, kann der Kondensator 24 im mittleren Bereich 34 eine Aussparung aufweisen.

## Patentansprüche

1. Schaltereinheit (100, 200) mit einem Grundteil (12) und einem gegenüber dem Grundteil bewegbaren Betätigungselement (14), wobei durch die Bewegung des Betätigungselements (14) ein elektrischer Kontakt schließbar ist, wobei die Schaltereinheit einen Berührungssensor (24, 26) umfasst, mit dem bei Berührung des Betätigungselements (14) oder bei Annäherung an das Betätigungselement ein Schaltsignal erzeugbar ist, und wobei der Berührungssensor Felderzeugungsmittel (24) zur Erzeugung eines elektrischen Feldes (28) und eine Auswerteelektronik (26) zur Überwachung der Änderung des elektrischen Feldes (28) und zur Erzeugung des Schaltsignals bei sich änderndem elektrischen Feld umfasst, **dadurch gekennzeichnet, dass** die Felderzeugungsmittel grundteilseitig unterhalb des Betätigungselements (14) angeordnet sind.

2. Schaltereinheit (200) nach Anspruch 1, **dadurch gekennzeichnet, dass** Felderzeugungsmittel am oder im bewegbaren Betätigungselement angeordnet sind, dass zwischen den Felderzeugungsmitteln und der Auswerteelektronik eine elektrische Kopplung vorgesehen ist, wobei die elektrische Kopplung ein weiteres, grundteilseitiges Felderzeugungsmittel (30) umfasst, wobei das betätigungselementseitige Felderzeugungsmittel (24) mit dem grundteilseitigen Felderzeugungsmittel (30) berührungslos derart in Wirkverbindung steht, dass eine Änderung des elektrischen Feldes des betätigungselementseitigen Felderzeugungsmittels (24) eine Änderung des elektrischen Feldes des grundteilseitigen Felderzeugungsmittels (30) bewirkt, wobei das grundteilseitige Felderzeugungsmittel (30) mit der Auswerteelektronik (26) verbunden ist.

3. Schaltereinheit (100, 200) nach Anspruch 1 oder 2, **dadurch gekennzeichnet, dass** die Auswerteelektronik grundteilseitig angeordnet ist.

4. Schaltereinheit (100, 200) nach einem der vorherigen Ansprüche, **dadurch gekennzeichnet, dass** die Felderzeugungsmittel durch Kondensatoren (24) gebildet sind.

5. Schaltereinheit (200) nach Anspruch 2 und 3 oder 2 und 4, **dadurch gekennzeichnet, dass** das die beiden Felderzeugungsmittel als Kondensatoren (24, 30) ausgebildet sind, wobei einer der Kondensatoren (24 beziehungsweise 30) den anderen Kondensator (30 beziehungsweise 24) wenigstens abschnittsweise überdeckt, umgibt oder umschließt.

6. Schaltereinheit (100, 200) nach einem der vorhergehenden Ansprüche, **dadurch gekennzeichnet, dass** das Betätigungselement (14) gegenüber dem Grundteil (12) eine Hub-, Dreh-, Schiebe- und/oder Pendelbewegung ausführen kann.

7. Schaltereinheit (100, 200) nach einem der vorhergehenden Ansprüche, **dadurch gekennzeichnet, dass** das eine Leuchtmittel (32) zur Beleuchtung des Betätigungselements (14) vorgesehen ist.

8. Schaltereinheit (100) nach Anspruch 7, **dadurch gekennzeichnet, dass** die Felderzeugungsmittel (24) zwischen dem Leuchtmittel (32) und dem Betätigungselement (14) angeordnet sind, wobei die Felderzeugungsmittel (24) einen Ausschnitt oder Durchbruch (34) für das von dem Leuchtmittel (32) ausgesendete Licht umfassen und das Betätigungselement (14) wenigstens abschnittsweise durchleuchtbar ist.

## Claims

1. A switch unit (100, 200) with a base element (12) and an actuating element (14) which is movable in respect to the base element, wherein an electrical contact can be closed by the movement of the actuating element (14), wherein the switch unit comprises a contact sensor (24, 26), by means of which a switching signal can be generated if the actuating element (14) is touched or when the actuating element is approached, and wherein the contact sensor comprises field-generating means (24) for generating an electrical field (28) and an electronic evaluation device (26) for monitoring the change in the electrical field (28), and for generating the switching signal when the electrical field changes, **characterized in that** the field-generating means are arranged in the base element below the actuating element (14).

2. The switch unit (200) in accordance with claim 1, **characterized in that** field-generating means are arranged at or in the movable actuating element, that an electrical connection is provided between the field-generating means and the electronic evaluation device, wherein the electrical connection comprises a further field-generating means (30) in the base element, wherein the field-generating means (24) at the actuating element is in a contactless operative connection with the field-generating means (30) at the base element in such a way that a change in the electrical field of the field-generating means (24) at the actuating element causes a change in the electrical field of the field-generating means (30) in the base element, wherein the field-generating means (3) in the base element is connected with the electronic evaluation device (26).

3. The switch unit (100, 200) in accordance with claim 1 or 2, **characterized in that** the electronic evaluation device is arranged at the base element.

4. The switch unit (100, 200) in accordance with one of the preceding claims, **characterized in that** the field-generating means is constituted by capacitors.

5. The switch unit (200) in accordance with claim 2 and 3 or 2 and 4, **characterized in that** the two field-generating means are embodied as capacitors (24, 30), wherein one of the capacitors (24 or 30) covers, surrounds or encloses the other capacitor (30 or 24), at least partially.

6. The switch unit (100, 200) in accordance with one of the preceding claims, **characterized in that** the actuating element (14) can perform a lifting, rotating, pushing and/or swinging movement in respect to the base element (12).

7. The switch unit (100, 200) in accordance with one of the preceding claims, **characterized in that** the one illuminating means (32) is provided for illuminating the actuating element (14).

8. The switch unit (100) in accordance with claim 7, **characterized in that** the field-generating means (24) is arranged between the illuminating means (32) and the actuating element (14), wherein the field-generating means (24) comprises a cutout or opening (34) for the light emitted by the illuminating means (32), and light can be passed through the actuating means (14) at least in part.

## Revendications

1. Unité de commutation (100, 200) comportant une partie de base (12) et un élément d'actionnement (14), mobile par rapport à la partie de base, un contact électrique pouvant être fermé sous l'effet du mouvement de l'élément d'actionnement (14), l'unité de commutation comportant un capteur de contact (24, 26), par lequel peut être délivré un signal de commutation en cas de contact avec l'élément d'actionnement (14) ou en cas d'approche de l'élément d'actionnement, et le capteur de contact comportant des moyens de formation de champ (24) destinés à générer un champ électrique (28) et une électronique d'analyse (26) destinée à surveiller la variation du champ électrique (28) et destinée à générer le signal de commutation en cas de variation du champ électrique, **caractérisée en ce que** les moyens de formation de champ du côté de la partie de base sont agencés en dessous de l'élément d'actionnement (14).

2. Unité de commutation (200) selon la revendication 1, **caractérisée en ce que** moyens de formation de champ sont agencés sur ou dans l'élément d'actionnement mobile, **en ce qu'**un couplage électrique est prévu entre les moyens de formation de champ et l'électronique d'analyse, le couplage électrique comportant un moyen de formation de champ (30) supplémentaire, du côté de la partie de base, le moyen de formation de champ (24) du côté de l'élément d'actionnement étant en liaison active sans contact avec le moyen de formation de champ (30) du côté de la partie de base, **en ce qu'**une variation du champ électrique du moyen de formation de champ (24) du côté de l'élément d'actionnement entraîne une variation du champ électrique du moyen de formation de champ (30) du côté de la partie de base, le moyen de formation de champ (30) du côté de la partie de base étant relié à l'électronique d'analyse (26).

3. Unité de commutation (100, 200) selon la revendication 1 ou 2, **caractérisée en ce que** l'électronique d'analyse est agencée du côté de la partie de base.

4. Unité de commutation (100, 200) selon l'une quelconque des revendications précédentes, **caractérisée en ce que** les moyens de formation de champ sont formés par des condensateurs (24).

5. Unité de commutation (200) selon les revendications 2 et 3 ou 2 et 4, **caractérisée en ce que** les deux moyens de formation de champ sont réalisés sous forme de condensateurs (24, 30), l'un des condensateurs (24 ou 30) couvrant, entourant ou enserrant au moins partiellement l'autre condensateur (30 ou 24).

6. Unité de commutation (100, 200) selon l'une quelconque des revendications précédentes, **caractérisée en ce que** l'élément d'actionnement (14) peut effectuer par rapport à la partie de base (12) un mouvement de levage, de rotation, de coulissement et/ou un mouvement oscillant.

7. Unité de commutation (100, 200) selon l'une quelconque des revendications précédentes, **caractérisée en ce qu'**il est prévu un moyen lumineux (32) pour éclairer l'élément d'actionnement (14).

8. Unité de commutation (100) selon la revendication 7, **caractérisée en ce que** les moyens de formation de champ (24) sont agencés entre le moyen lumineux (32) et l'élément d'actionnement (14), les moyens de formation de champ (24) comportant une découpe ou un passage (34) pour la lumière émise par le moyen lumineux (32) et l'élément d'actionnement (14) peut être éclairé de part en part au moins par zones.
